Europäisches Patentamt

European Patent Office

Office européen des brevets

(19)

(11) **EP 0 618 675 B1**

(12) **FASCICULE DE BREVET EUROPEEN**

| | |
|---|---|
| (45) Date de publication et mention de la délivrance du brevet: **06.05.1999 Bulletin 1999/18** | (51) Int Cl.⁶: **H03G 3/00**, H03G 1/02 |

(21) Numéro de dépôt: **94400541.2**

(22) Date de dépôt: **14.03.1994**

(54) **Dispositif électronique à faible consommation**

Elektronische Vorrichtung mit geringem Leistungsverbrauch

Electronic device with low power consumption

(84) Etats contractants désignés:
**DE ES GB IT**

(30) Priorité: **19.03.1993 FR 9303192**

(43) Date de publication de la demande:
**05.10.1994 Bulletin 1994/40**

(73) Titulaire: **VALEO ELECTRONIQUE**
**94042 Creteil Cédex (FR)**

(72) Inventeur: **Rydel, Charles**
**F-75019 Paris (FR)**

(74) Mandataire: **Gamonal, Didier et al**
**Valeo Management Services**
**Propriété Industrielle**
**2, rue André Boulle,**
**B.P. 150**
**94004 Créteil (FR)**

(56) Documents cités:
**US-A- 5 159 280**

- **JOHN MARKUS 'electronic circuits manual' 1971 , MC GRAW-HILL BOOK COMPANY , NEW YORK * pg 142 the top left figure: ?both polarities from one' ***

## Description

La présente invention telle qu'elle est définie dans les revendications concerne un dispositif électronique constitué d'au moins deux étages électroniques et dont on veut réduire la consommation électrique.

Le document US-A-5 159 280 divulgue une exemple de dispositif électronique à plusieurs étages.

Dans l'art antérieur, on sait déjà connecter les étages d'un dispositif électronique les uns par rapport aux autres de façon à composer des fonctions de transfert de façon à transformer un signal d'entrée en un signal de sortie adapté au but auquel est destiné le dispositif.

Chaque étage est connecté entre une ligne de tension positive d'alimentation continue et une ligne de tension négative d'alimentation, ces deux lignes étant communes aux étages du dispositif.

Cependant les montages de l'art antérieur, quand ils comportent un grand nombre d'étages, tirent un courant important sur l'alimentation continue pour fonctionner sous une tension continue d'alimentation donnée. En particulier, ceci est un réel inconvénient quand le dispositif électronique est embarqué à bord d'un véhicule et qu'il tire sa tension d'alimentation d'une batterie, dont la charge s'épuise au cours du temps. C'est le cas des dispositifs électroniques portables qui tirent leur énergie électrique d'une source comme une batterie, des piles, des accumulateurs ou des cellules photoélectriques.

L'effet négatif est d'autant plus accentué que le dispositif est utilisé en veille, comme c'est le cas pour un récepteur de télécommande. En effet, dans ce cas au moins une partie du récepteur doit être alimenté en permanence de façon à pouvoir détecter à tout moment l'arrivée d'un signal de commande, comme signal d'entrée. C'est pourquoi, dans l'art antérieur, on a déjà proposé des dispositifs électroniques comportant au moins deux étages dont des bornes d'alimentation sont connectés en série entre deux bornes d'alimentation du dispositif et dont des bornes d'entrée et de sortie de signal sont montées en cascade.

Un tel dispositif est par exemple décrit dans le document EP-A-0 060 164, conforme au préambule de la revendication 1.

Ce dispositif connu comporte deux étages amplificateurs de tension et un circuit de correction automatique de gain.

Toutefois ce circuit comprend des circuits à impédance variable, fonction de la valeur d'un signal appliqué sur leur entrée de commande.

La présente invention propose un perfectionnement à ce type de circuit permettant d'obtenir une correction automatique de gain avec des moyens relativement simples.

Selon l'invention, ce but est atteint par l'objet de la partie caractérisante de la revendication 1.

D'autres caractéristiques et avantages de la présente invention apparaîtront plus clairement à l'aide de la description et des dessins qui sont :

- la figure 1 : un premier mode de réalisation d'un dispositif selon l'invention ;
- la figure 2 : un second mode de réalisation d'un dispositif selon l'invention ;
- la figure 3 : un dispositif selon l'invention équipé d'un moyen supplémentaire ;
- la figure 4 : un moyen de contrôle automatique d'un paramètre électrique d'au moins l'un des étages du dispositif de la figure 3.

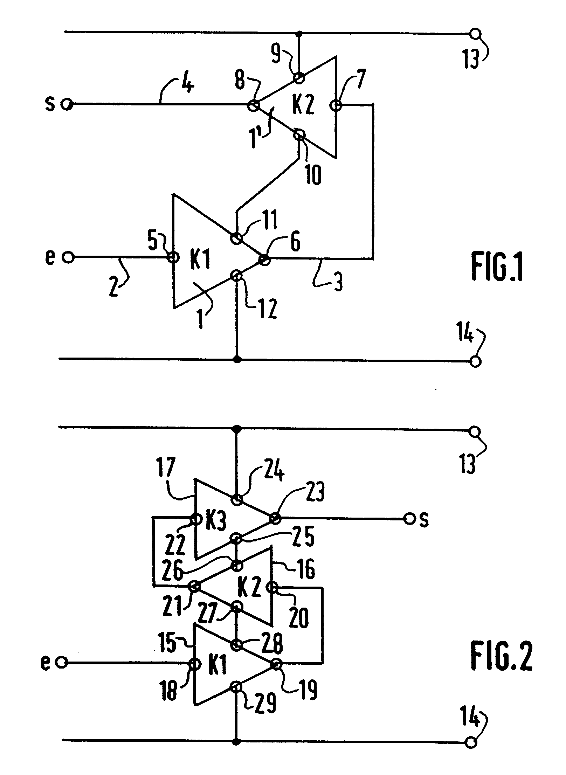

A la figure 1, on a représenté un schéma de principe d'un premier mode de réalisation d'un dispositif électronique selon l'invention.

Le dispositif de l'invention comporte principalement un premier étage 1 et un second étage 1', qui comportent respectivement une borne d'entrée de signal 5 ou 7 et une borne de sortie de signal 6 ou 8, ainsi que des bornes d'alimentation en tension continue respectivement 9 et 11 pour le potentiel haut ou positif, et 10 et 11 pour le potentiel bas ou négatif.
Selon l'invention, la borne d'entrée de signal du dispositif, référencée e, est transmise par une liaison 2 à la borne d'entrée de signal 5 du premier étage 1. La borne de sortie de signal 6 du premier étage 1 est connectée par une liaison 3 à la borne d'entrée de signal 7 du second étage 1'. La borne de sortie de signal 8 du second étage 1' est connectée par une liaison 4 à la borne de sortie de signal s du dispositif de l'invention.

Selon l'invention, bien que les étages 1 et 1' soient, au point de vue du signal, montés en cascade, les étages 1 et 1' sont montés en série entre une première borne d'alimentation 13 de potentiel haut (ou positif) et une seconde borne 14 d'alimentation de potentiel bas (ou négatif). A cette fin, le second étage 1' est connecté par sa borne 9 d'alimentation positive à la borne d'alimentation 13 de potentiel haut (ou positif), tandis que sa borne 10 d'alimentation négative ou nulle est connectée à la borne 11 d'alimentation positive du premier étage 1, dont la borne 12 d'alimentation négative est connectée à la borne d'alimentation 14 de potentiel bas (ou négatif).

Si on pose que les résistances équivalentes d'alimentation, en l'absence de signal par exemple, dans le dispositif électronique sont respectivement R1 entre les bornes 9 et 10 pour le premier étage 1 et R2 entre les bornes 11 et 12 pour le deuxième étage 1', et en désignant par Ua la tension d'alimentation continue entre les bornes 13 et 14, on remarque que la puissance consommée peut s'écrire $P = Ua^2 / (R1 + R2)$.

Dans l'art antérieur, on remarque que les bornes d'alimentation positive respectivement 11 et 9, des premier 1 et second 1' étages seraient connectées toutes les deux à la ligne 13, tandis que les bornes d'alimentation négative, respectivement 12 et 10, seraient connectées en commun à la ligne 14. Dans ce cas, la puissance consommée serait supérieure et s'exprimerait par :

$$P = Ua^2/R1 + Ua^2/R2$$

Selon l'invention, il est possible d'augmenter le nombre des étages, dans la limite où la différence de tension, entre les bornes de plus haute tension continue et de plus basse tension continue, est suffisante pour chacun des étages de façon à polariser convenablement le montage.

Dans le dispositif de la figure 1, le signal de sortie produit s'écrit S(p) = K1 X K2 E(p)

si K1 et K2 désignent les fonctions de transfert des étages 1 et 1', et E(p) et S(p) les transformées de Laplace des signaux d'entrée e et de sortie s du dispositif.

Le dispositif de l'invention s'applique en particulier quand les étages 1 et 1' sont des amplicateurs ou des filtres ou des combinaisons de ces deux types de montage.

A la figure 2, on a représenté un mode de réalisation où on a connecté en cascade, au point de vue du signal, trois étages respectivement 15, 16, 17, et qui sont montés en série entre les lignes 13 et 14 d'alimentation.

Comme précédemment, la borne d'entrée de signal du dispositif, e, est connectée par une liaison convenable à la borne d'entrée 18 du premier étage 15, dont la borne de sortie 19 est connectée à la borne d'entrée 20 du second étage 16, dont la borne de sortie 21 est connectée à la borne d'entrée 22 de l'étage 17, dont la borne de sortie 23 est connectée à la borne de sortie du montage s.

La borne 24 d'alimentation positive du troisième étage 17 est connectée à la borne d'alimentation 13 du dispositif, tandis que sa borne 25 d'alimentation négative est connectée à la borne 26 d'alimentation positive du second étage 16. La borne 25 d'alimentation négative du second étage 16 est connectée à la borne 28 d'alimentation positive du premier étage 15. La borne d'alimentation 29 négative du premier étage 15 est connectée à la borne d'alimentation négative (ou nulle) du dispositif. La limite du nombre d'étages, qu'il est possible de monter en série, dépend de la tension minimale de polarisation de chacun des étages.

Aujourd'hui, en utilisant notamment les composants de type MOS, il est possible de travailler par exemple jusqu'à des tensions continues de polarisation de l'ordre de 3 Volts et parfois moins, et en utilisant une tension continue élevée Ua par exemple de l'ordre de 24 Volts, on conçoit qu'il est possible de monter un grand nombre de dispositifs en cascade selon les schémas des figures 1 ou 2.

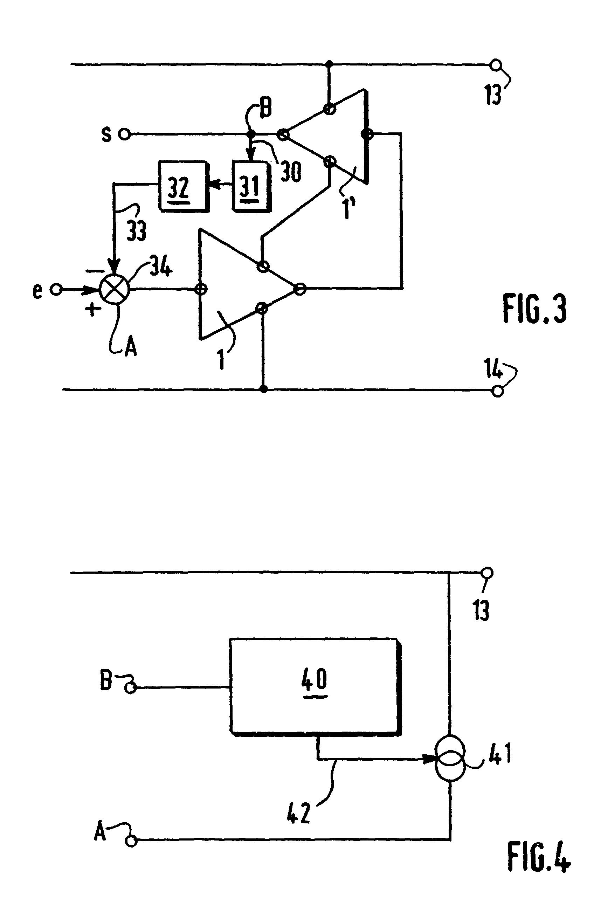

A la figure 3, on a représenté un moyen supplémentaire adapté au montage de la figure 1. Dans ce dispositif, on suppose que les étages 1 et 1' sont des amplificateurs de tension. Ils sont connectés comme il est représenté à la figure 1 et leur connexion à l'alimentation continue n'est pas décrite plus avant. On réalise à l'aide du montage de la figure 3, une correction sur au moins un paramètre du signal de sortie. En particulier, ainsi qu'on le verra plus loin, on peut exécuter ici facilement une correction automatique de gain CAG en réalisant par une connexion 30 une détection du signal de sortie s en sortie du second étage 1'.

Le moyen supplémentaire de l'invention comporte un circuit détecteur 31 dont le signal de sortie commande un générateur de signal de la correction 32 qui est connecté par une liaison 33 à un élément d'addition 34 sur la voie d'entrée e. Le signal d'entrée e est transmis par exemple à une borne d'alimentation positive, référencée + au dessin, de l'additionneur 34, tandis que le signal de sortie de la correction est connecté à une borne négative, référencée - au dessin, de l'additionneur 34. Dans le mode de réalisation représenté à la figure 3, la correction automatique travaille de manière négative.

Dans un mode de réalisation, la correction automatique est exercée sur une partie seulement de la bande passante du signal de sortie s. Dans ce mode de réalisation, on utilise un filtre passe-bande inséré sur la voie 30 à titre de moyen permettant de limiter la correction automatique sur une partie seulement du signal de sortie. Il est clair que la correction peut être appliquée sur une partie seulement de l'amplitude du signal, ou sur toute autre caractéristique du signal de sortie.

A la figure 4, on a représenté un autre montage qui permet de réaliser une correction automatique d'un paramètre électrique de l'un des étages montés en cascade dans le dispositif. Il est en effet connu que un paramètre électrique comme la tension de sortie, ou le gain, ou la bande passante d'un étage électrique comportant un transistor ou un dispositif du même genre soit réglable par modification du courant d'entrée.

C'est en particulier le cas de la correction automatique de gain CAG. Dans le montage de la figure 1, il suffit de diminuer le courant dans le transistor 1 pour diminuer réciproquement celui dans le transistor 1'.

La variation de courant est réalisée à l'aide d'un dispositif 40 de détection de niveau, qui reçoit le signal de sortie prélevé sur la connexion 3 de la figure 1 et qui produit un signal de sortie de détection 42 qui sert à contrôler une source de courant 41 connectée entre la ligne d'alimentation de potentiel haut (ou positif) 13 et un point A de sommation des courants sur l'entrée du transistor 1. Quand on veut réaliser une correction automatique de gain à l'aide du montage de la figure 4, il suffit d'augmenter plus ou moins l'extraction de courant vers l'alimentation et on élève ainsi le potentiel Ve, et comme la tension $V_B$ reste fixe, le courant de collecteur diminue dans le transistor 1 et donc dans le transistor 1'.

A la Figure 4, on a représenté la correction automatique de gain décrite ci-dessus comme correction envisagée dans le moyen supplémentaire décrite avec la Figure 3.

Le dispositif de la Figure 4 présente un circuit de correction automatique de gain. Le circuit de correction comporte un moyen de détection 40 du niveau du signal de sortie B d'un étage donné 1' du dispositif. Seule imposition, cet étage donné ne doit pas être l'étage d'entrée du dispositif. Sa sortie est connectée à l'électrode de commande 42 d'une source de courant commandable 41. Une telle source de courant commandable peut facilement être réalisée à l'aide d'un transistor. Sa sortie est connectée à l'entrée - de l'additionneur 34 disposé à l'entrée d'un étage précédent 1 sur lequel la correction automatique de gain est appliquée. En fonction de la programmation de la correction automatique de gain, par exemple en fonction de la bande passante, le moyen de correction retire plus ou moins de courant dans l'étage précédent 1 et, de ce fait, retire plus ou moins du niveau de tension de sortie de l'étage de sortie 1'.

## Revendications

1. Dispositif électronique comprenant au moins deux étages (1,1') amplificateurs de tension, chacun comportant des bornes d'entrée (5, 7) et de sortie (6, 8) de signal et des bornes d'alimentation en tension (11, 12 ; 9, 10), les bornes d'alimentation des étages (1, 1') étant connectées en série entre deux bornes (13, 14) d'alimentation du dispositif, les bornes d'entrée et de sortie de signal (5, 6, 7, 8) des étages (1, 1') étant montées en cascade, et comprenant un circuit de correction automatique de gain, caractérisé en ce que ledit circuit comporte un moyen de détection (40) du niveau du signal de sortie (B) d'un étage donné (1') du dispositif, autre que l'étage d'entrée, et dont la sortie est connectée à l'électrode de commande (42) d'une source de courant commandable (41) dont la sortie est connectée à l'entrée (-) d'un additionneur (34) disposé à l'entrée d'un étage précédent (1) sur lequel la correction automatique de gain est appliquée.

2. Dispositif selon la revendication 1 caractérisé en ce que la source de courant commandable (41) comprend un transistor.

3. Dispositif selon la revendication 1, caractérisé en ce que la correction est de type négative.

4. Dispositif selon l'une des revendications précédentes, caractérisé en ce que les étages comportent également des filtres.

5. Dispositif selon l'une des revendications précédentes, caractérisé en ce que chaque étage reçoit une tension de polarisation a moins égale à sa tension de polarisation minimum.

## Patentansprüche

1. Elektronische Vorrichtung, enthaltend mindestens zwei Spannungsverstärkerstufen (1, 1'), die jeweils Signaleingangs- (5, 7) und Signalausgangsanschlüsse (6, 8) und Spannungsversorgungsanschlüsse (11, 12; 9, 10) umfassen, wobei die Versorgungsanschlüsse der Stufen (1, 1') zwischen zwei Versorgungsanschlüssen (13, 14) der Vorrichtung in Reihe geschaltet sind, während die Signaleingangs- und Signalausgangsanschlüsse (5, 6, 7, 8) der Stufen (1, 1') in Kaskade geschaltet sind, und enthaltend eine Schaltung zur automatischen Korrektur des Verstärkungstaktors, **dadurch gekennzeichnet,** daß die besagte Schaltung ein Erfassungsmittel (40) für den Pegel des Ausgangssignals (B) einer gegebenen Stufe (1') der Vorrichtung umfaßt, bei der es sich nicht um die Eingangsstufe handelt, dessen Ausgang an die Steuerelektrode (42) einer steuerbaren Stromquelle (41) angeschlossen ist, deren Ausgang an den Eingang (-) eines Addierers (34) angeschlossen ist, der am Eingang einer vorangehenden Stufe (1) angeordnet ist, an der die automatische Korrektur des Verstarkungsfaktors angewendet wird.

2. Vorrichtung nach Anspruch 1 , **dadurch gekennzeichnet,** daß die steuerbare Stromquelle (41) einen Transistor umfaßt.

3. Vorrichtung nach Anspruch 1 , **dadurch gekennzeichnet,** daß die Korrektur negativen Typs ist.

4. Vorrichtung nach einem der vorangehenden Ansprüche, **dadurch gekennzeichnet,** daß die Stufen außerdem Filter umfassen.

5. Vorrichtung nach einem der vorangehenden Ansprüche, **dadurch gekenneichnet,** daß jede Stufe eine Vorspannung mindestens gleich ihrer minimalen Vorspannung erhält.

## Claims

1. An electronic device including at least two voltage amplifying stages (1, 1'), each having signal input terminals (5, 7) and signal output terminals (6, 8) and voltage supply terminals (11, 12; 9, 10), the supply terminals of the stages (1, 1') being connected in series between two power supply terminals (13, 14) of the device, the signal input and output terminals (5, 6, 7, 8) of the stages (1, 1') being connected in cascade, and further including an automatic gain correction circuit, characterised in that the said circuit comprises a means (40) for detecting the level of the output signal (B) of a given stage (1') of the device other than the input stage, and having its output connected to the control electrode (42) of a controllable current source (41), the output of which is connected to the input (-) of an adder (34) disposed at the input of a preceding stage (1) on which the automatic gain correction is applied.

2. A device according to Claim 1, characterised in that the controllable current source (41) comprises a transistor.

3. A device according to Claim 1, characterised in that the correction is of negative type.

4. A device according to one of the preceding Claims, characterised in that the stages further include filters.

5. A device according to one of the preceding Claims, characterised in that each stage receives a polarisation voltage at least equal to its minimum polarisation voltage.

FIG.1

FIG.2

FIG.3

FIG.4